(19) Europäisches Patentamt
European Patent Office
Office européen des brevets

(11) **EP 2 752 856 A1**

(12) **EUROPEAN PATENT APPLICATION**
published in accordance with Art. 153(4) EPC

(43) Date of publication:
**09.07.2014 Bulletin 2014/28**

(51) Int Cl.:
*H01B 12/10* [(2006.01)]   *C22C 9/02* [(2006.01)]
*C22C 27/02* [(2006.01)]   *H01B 13/00* [(2006.01)]
*H01F 6/06* [(2006.01)]   *C22F 1/00* [(2006.01)]
*C22F 1/08* [(2006.01)]

(21) Application number: **12827135.0**

(22) Date of filing: **29.08.2012**

(86) International application number:
**PCT/JP2012/071838**

(87) International publication number:
**WO 2013/031830 (07.03.2013 Gazette 2013/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.08.2011 JP 2011187637**

(71) Applicant: **Japan Superconductor Technology, Inc.**
**Kobe-shi, Hyogo 651-2271 (JP)**

(72) Inventors:
• **MURAKAMI, Yukinobu**
**Kitakyushu-shi**
**Fukuoka 800-0007 (JP)**
• **KURAHASHI, Hidefumi**
**Kitakyushu-shi**
**Fukuoka 800-0007 (JP)**
• **KATO, Hiroyuki**
**Kitakyushu-shi**
**Fukuoka 800-0007 (JP)**

(74) Representative: **Nevant, Marc et al**
**Cabinet Beau de Loménie**
**158, rue de l'Université**
**75340 Paris Cedex 07 (FR)**

(54) **PRECURSOR FOR MANUFACTURING NB3SN SUPERCONDUCTING WIRE MATERIAL AND NB3SN SUPERCONDUCTING WIRE MATERIAL**

(57) The strength of a superconducting wire material is increased to over that of conventional superconducting wire materials. A precursor (1) (precursor for manufacturing an $Nb_3Sn$ superconducting wire material) is provided with: a superconducting matrix section (2) in which a plurality of Nb-based filaments (5) containing pure Nb or a Nb-based alloy are arranged in a bronze matrix section (4) (Cu-Sn-based alloy) ; a diffusion barrier layer (6) arranged on the outer periphery of the superconducting matrix section (2); a stabilization copper layer (7) arranged on the outer periphery of the diffusion barrier layer (6) ; and a reinforcing member (8), which is arranged in the superconducting matrix section (2) and which contains pure Ta or a Ta-based alloy. The reinforcing member (8) occupies an area ratio of 15-25% of the cross-section perpendicular to the axis of the precursor (1).

FIG. 1

EP 2 752 856 A1

**Description**

Technical Field

The present invention relates to a precursor for manufacturing a $Nb_3Sn$ superconducting wire, and a $Nb_3Sn$ superconducting wire manufactured by using such a precursor.

Background Art

PTL 1 describes a traditional $Nb_3Sn$ superconducting wire. This superconducting wire is used as a winding wire for a coil of a superconducting magnet, or the like. Such a superconducting magnet is used in a nuclear magnetic resonance (NMR) analyzer, a physical property evaluation equipment, an electricity storage, a nuclear fusion reactor, or the like.

Citation List

*Patent Literature*

[PTL 1] Japanese Unexamined Patent Publication No. 255563/1998 (Tokukaihei 10-255563)

Summary of Invention

*Technical Problem*

As stated hereinbelow, a traditional superconducting wire has a problem of insufficient strength. Namely, a superconducting wire used as a winding wire for a coil is subject to a strong electromagnetic force, which causes deformation. This deformation, when becoming significant, causes a drop in the critical current of the $Nb_3Sn$ superconducting wire (i.e., the critical current characteristic is deteriorated). Such a deformation-attributed drop in the critical current of the $Nb_3Sn$ superconducting wire has been inevitable.

To restrain the deformation, the technology of PTL 1 achieves a high strength of the superconducting wire. Specifically, a Ta layer or a Ta alloy layer is provided to reinforce the superconducting wire (see reference numeral 4 appearing in FIG. 2 and the like of PTL 1).

PTL 1 however does not describe an area ratio (hereinafter "area ratio A") of the Ta layer or the Ta alloy layer in a cross-section of the superconducting wire or the precursor, perpendicular to the axis of the superconducting wire or the precursor. A superconducting wire practically used or its precursor occupies an area ratio A of approximately 10%. The 0.2% yield strength of such a superconducting wire occupying an area ratio A of 10% is less than 300 MPa, and this strength, in some cases, may fall short. As the magnetic field of the superconducting magnet becomes higher and the superconducting magnet becomes more compact, a stronger electromagnetic force acts on the superconducting wire, leading to a demand for a superconducting wire with a higher strength.

It is therefore an object of the present invention to provide a precursor for manufacturing a $Nb_3Sn$ superconducting wire having a higher strength than a traditional superconducting wire.

*Technical Solution*

A precursor of the present invention for manufacturing a $Nb_3Sn$ superconducting wire is a precursor for use in manufacturing a $Nb_3Sn$ superconducting wire, including: a superconducting matrix section in which a plurality of Nb-based filaments containing pure Nb or a Nb-based alloy are arranged in a Cu-Sn-based alloy; a diffusion barrier layer having the superconducting matrix section arranged on its outer periphery; a stabilization copper layer arranged on an outer periphery of the diffusion barrier layer; and a reinforcing member arranged in the superconducting matrix section, which contains pure Ta or a Ta-based alloy. The reinforcing member occupies an area ratio of 15 to 25% of a cross-section of the precursor perpendicular to the axis of the precursor. A Sn concentration in the Cu-Sn-based alloy of the superconducting matrix section is 13.5% by mass or higher.

*Advantageous Effects*

The above-described structure allows manufacturing a $Nb_3Sn$ superconducting wire having a higher strength than a traditional superconducting wire.

Brief Description of the Drawings

FIG. 1 is a cross sectional view seen from an axial direction of a precursor for manufacturing a $Nb_3Sn$ superconducting wire.

FIG. 2 is a graph indicating the relation between an area ratio of a reinforcing member 8 shown in FIG. 1, a critical current density, and the 0.2% yield strength.

FIG. 3 is a FIG. 1-equivalent figure of an alternative form 1.

Description of Embodiments

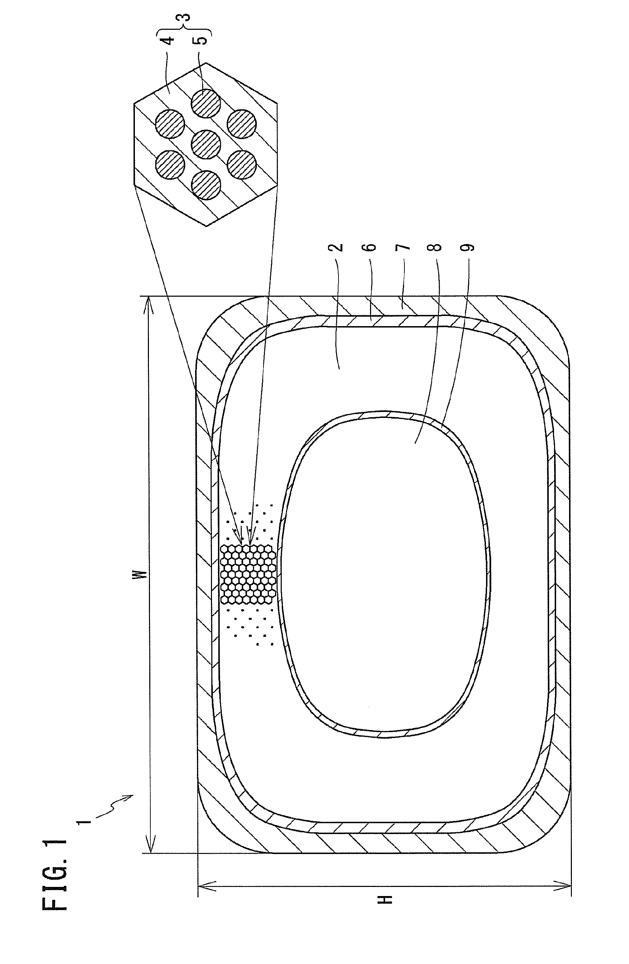

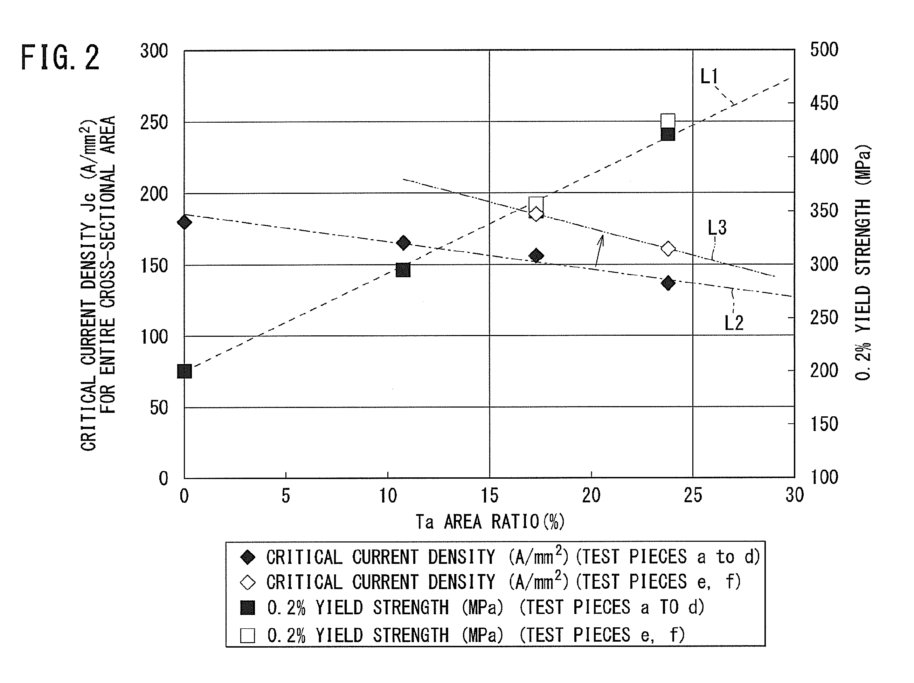

The following describes a precursor 1 (precursor for manufacturing a $Nb_3Sn$ superconducting wire) or the like of an embodiment of the present invention, with reference to FIG. 1 and FIG. 2. First described is a superconducting wire ($Nb_3Sn$ superconducting wire) manufactured by using a precursor 1.

A superconducting wire ($Nb_3Sn$ superconducting wire) is manufactured by subjecting a precursor 1 shown in FIG. 1 to a $Nb_3Sn$ reaction heat treatment so as to form a $Nb_3Sn$-based superconductive phase (the method of manufacturing is described hereinbelow). The structure of a cross-section of the superconducting wire perpendicular to the axis of the superconducting wire (cross-section perpendicular to the axial direction, cross-section viewed in the axial direction) is substantially the same as a later-described structure of the cross-section of the precursor 1 perpendicular to the axis of the precursor 1. The superconducting wire is, for example, used as a winding wire for a coil of a superconducting magnet. When the coil is excited, the superconducting wire, due to the electromagnetic force, receives a force (hoop force) which expands radially outwardly of the coil. As the result, a tensile load in the axial direction is given to the superconducting wire, consequently deforming the same. This deformation causes a drop in the critical current of the superconducting wire (deteriorates the critical current characteristic). In view of this, the strength of the superconducting wire is set so as to be able to sufficiently restrain the deformation.

Precursor 1 (precursor for manufacturing the $Nb_3Sn$ superconducting wire) is a wire for use in manufacturing a $Nb_3Sn$ superconducting wire by a bronze process. Precursor 1 is a precursor before the $Nb_3Sn$ reaction heat treatment. Precursor 1 is a precursor obtained after wire-drawing a secondary multifilament billet having been obtained by hydrostatic extrusion.

The shape of the cross-section of precursor 1 perpendicular to the axis of precursor 1 (hereinafter, axis-perpendicular cross-section of precursor 1) is formed so as to reduce the dead space when the superconducting wire manufactured by using precursor 1 is used to form a coil. Specifically, the axis-perpendicular cross-section of precursor 1 is rectangular (rectangular including a square). That is, precursor 1 is a rectangular wire. It should be noted that the wording "rectangular" encompasses a rectangle with four rounded corners. However, the closer the four corners are to the right angle, the less the dead space is. However, the "rectangular" shape requires a straight portion between one corner and another corner (except the opposite angle) of the "rectangular" shape. More specifically, to form a "rectangular" shape, the periphery of the axis-perpendicular cross-section of precursor 1 needs to include a set of two straight lines parallel to each other and another set of two straight lines parallel to each other and perpendicular to the aforementioned set of two straight lines (the wording "parallel" and "perpendicular" encompass "substantially parallel" and "substantially perpendicular"). Where the long side length of the axis-perpendicular cross-section of precursor 1 is W and the short side length is H, the W/H is for example from 1.2 to 2.0 (however the W/H is not limited to such a range). Note that the shape of the axis-perpendicular cross-section of precursor 1 may be a shape other than a rectangular shape; e.g., a circular or an ellipsoidal shape.

Precursor 1 includes: a superconducting matrix section 2, a diffusion barrier layer 6 and a stabilization copper layer 7 arranged on the periphery (radially outside) of the superconducting matrix section 2, a reinforcing member 8 arranged inside the superconducting matrix section 2, and an intermediate layer 9 arranged between the reinforcing member 8 and the superconducting matrix section 2.

The superconducting matrix section 2 has a structure in which a plurality of Nb-based filaments 5 are arranged in a Cu-Sn-based alloy (bronze matrix section 4). The superconducting matrix section 2 includes a plurality of multifilament sections 3 in number of, for example, several tens, a hundred and several tens, several hundreds (FIG. 1 illustrates a part of the plurality of multifilament sections 3). Each multifilament section 3 includes a bronze matrix section 4 and a plurality of Nb-based filaments 5 arranged within the bronze matrix section 4.

The bronze matrix section 4 contains a Cu-Sn-based alloy. The material of the bronze matrix section 4 is entirely or mostly the Cu-Sn-based alloy. The Cu-Sn-based alloy contains, for example, approximately 0.3 to 0.5% by mass of Ti (other elements may be contained as hereinbelow mentioned). The cross-section of the bronze matrix section 4 perpendicular to the axis of the bronze matrix section 4 is a hexagon for example (however it may be a circle and the like).

The higher the concentration of Sn (hereinafter simply referred to as "Sn concentration") in the Cu-Sn-based alloy forming the bronze matrix section 4, the higher the critical current density (Jc) becomes (the higher the critical current density of the superconducting wire manufactured by precursor 1 becomes). The Sn concentration is set according to the critical current density required. Specifically, the Sn concentration is 13.5% by mass or higher, preferably 14% by mass or higher, and more preferably 15% by mass or higher. Usually, the Sn concentration can be increased up to 15.6% by mass at room temperature. With at least one of Ti and Zr in the Cu-Sn-based alloy, the Sn concentration can be increased up to 19% by mass.

The Sn concentration is described further in detail later. The Sn concentration usually cannot be over 15.6% by mass at room temperature. This is because an intermetallic compound of Cu-Sn is generated if more than 15.6% by mass of Sn is provided in the Cu-Sn-based alloy. A typical intermetallic compound of Cu-Sn is "$\delta$ phase". This $\delta$ phase is hard and poor in ductility, and therefore causes deterioration in the workability of precursor 1 at the time of manufacturing (workability in a later mentioned area reduction process). In view of this, at least one of Ti and Zr is provided in the Cu-Sn-based alloy. This eliminates the $\delta$ phase in the Cu-Sn-based alloy. As the result, the Cu-Sn-based alloy is able to contain Sn of more than 15.6% by mass which is the solubility limit at room temperature. Specifically, it is possible to increase the Sn concentration up to 19% by mass.

Nb-based filament 5 contains pure Nb or a Nb-based alloy. The material of the Nb-based filament 5 is entirely or mostly pure Nb or the Nb-based alloy. Pure Nb may contain a very small amount of impurity (e.g., less than 0.5% by mass). The Nb-based alloy is an alloy containing approximately 0.5% to 10% by mass of an additional element (e.g., Ta, Hf, Zr, Ti, and the like). In a single multicore section 3, there are, for example, seven Nb-based filaments 5 (the number of the Nb-based filaments however may be six or less, or eight or more). Note that a reference numeral is given to only one of the seven Nb-based filaments 5 shown in FIG. 1. The shape of the cross-section of the Nb-based filament 5 perpendicular to the axis of the Nb-based filament 5 is a circle (however not limited to a circular shape).

Reducing the diameter of the Nb-based filament 5 (if the cross-section perpendicular to the axis does not have a circular shape, the diameter of a circle whose area is equal to the area of the cross-section (equivalent diameter)) causes an increase in the critical current density. However, a reduction of the diameter of the Nb-based filament 5 also causes a decrease in an n-value. The n-value is a value indicating the sharpness of the transition from the superconductive state to a normal conducting state. The (equivalent) diameter D5 of the Nb-based filament 5 is set so that the ratio of the (equivalent) diameter D5 of the Nb-based filament to the equivalent diameter D8 of the later-mentioned reinforcing member 8, i.e., "D5/D8" is within a range from, for example, 0.001 to 0.015, preferably within a range from 0.003 to 0.011.

The diffusion barrier layer 6 is a layer for restraining the expansion of Sn in the superconducting matrix section 2 towards the outside (towards the stabilization copper layer 7), during the Nb$_3$Sn reaction heat treatment. The diffusion barrier layer 6 is arranged on the outer periphery (radially outside) of the superconducting matrix section 2 and on the inner periphery (radially inside) of the stabilization copper layer 7. The diffusion barrier layer 6 includes at least one of a Nb layer and a Ta layer. The innermost layer of the diffusion barrier layer 6 (a portion contacting the superconducting matrix section 2) is preferably the Ta layer. This is because, when the innermost layer of the diffusion barrier layer 6 is the Nb layer and not the Ta layer, the Nb layer of the diffusion barrier layer 6 reacts with the Sn in the superconducting matrix section 2 during the Nb$_3$Sn reaction heat treatment, which forms a Nb$_3$Sn superconductive phase nearby the diffusion barrier layer 6. This causes an increase in the diameter of the effective filament and causes an increase in the AC loss. Note that the Ta layer as the diffusion barrier layer 6 is not included in the later-described reinforcing member 8. Further, the diffusion barrier layer 6 and the superconducting matrix section 2 are not necessarily adjacent to each other. For example, a Cu-Sn-based alloy layer (not shown) or the like may be interposed between the diffusion barrier layer 6 and the superconducting matrix section 2.

The stabilization copper layer 7 is arranged on the outer periphery (radially outside) of the diffusion barrier layer 6. The stabilization copper layer 7 prevents the superconductive phase from burning out due to the overcurrent flowing to the superconductive phase, when the superconducting wire makes transition from the superconductive state to the normal conducting state. Note that the shape of the cross-section of the stabilization copper layer 7 perpendicular to the axis of the stabilization copper layer 7, while the stabilization copper layer 7 surrounds the outer peripheral end portion, forms the shape of the axis-perpendicular cross-section of precursor 1.

The reinforcing member 8 is a member for reinforcing the superconducting wire. The cross-section of the reinforcing member 8 perpendicular to the axis of the reinforcing member 8 (hereinafter, axis-perpendicular cross-section of the reinforcing member 8) has, for example, a substantially ellipsoidal shape (a circular or a rectangular shape is also possible). The reinforcing member 8 is arranged in the superconducting matrix section 2. In other words, the reinforcing member 8 is arranged radially inner-side of the outer peripheral end portion of the superconducting matrix section 2. Specifically, the reinforcing member 8 is centralized (converged at, arranged at the center of) the cross-section of the superconducting matrix section 2 perpendicular to the axis of the superconducting matrix section 2 (hereinafter, axis-perpendicular cross-section of the superconducting matrix section 2) (the other arrangements are described hereinafter). The word "converged" here means to arrange things collectively only in a single position instead of separately arranging things in a plurality of positions

(e.g., in a dispersed manner). The reinforcing member 8 being "arranged at the center" means that the reinforcing member 8 is arranged generally at the center of the axis-perpendicular cross-section of the superconducting matrix section 2. However, the reinforcing member 8 does not necessarily have to be arranged at the very center point of the axis-perpendicular cross-section of the superconducting matrix section 2. More specifically, to be "arranged at the center", the entire outer periphery of the axis-perpendicular cross-section of the reinforcing member 8 needs to be inside the superconducting matrix section 2. For example, if there is no superconducting matrix section 2 between the outer periphery of the axis-perpendicular cross-section of the reinforcing member 8 and the diffusion barrier layer 6, the reinforcing member 8 is not considered to be "arranged at the center".

The reinforcing member 8 contains pure Ta or a Ta-based alloy. The reinforcing member 8 is entirely or mostly made of the pure Ta or the Ta-based alloy. Pure Ta may contain a very small amount of impurity (e.g., 0.5% by mass). Pure Ta is preferably pure Ta for industrial use (e.g., Electron-Beam Cast, Vacuum-Arc Cast Unalloyed Tantalum of ASTM B708), as it is relatively easily available. Further, the Ta-based alloy forming the reinforcing member 8 is an alloy containing approximately 0.5% to 10% by mass of an additional element. The Ta-based alloy is harder than pure Ta. Therefore, the workability at the time of manufacturing precursor 1 (workability in a later mentioned area reduction process) is better when forming the reinforcing member 8 formed with the pure Ta, as compared with a case of forming the reinforcing member 8 with the Ta-based alloy. Further, the strength of the reinforcing member 8 (of the superconducting wire) is higher when forming the reinforcing member 8 with the Ta-based alloy, as compared with a case of forming the reinforcing member 8 with pure Ta. Since the additional element in the Ta-based alloy exceeding 10% by mass spoils the workability, the additional element is preferably not more than 10% by mass.

The reinforcing member 8 occupies an area ratio A of 15 to 25% (15% or higher but not more than 25%) of the axis-perpendicular cross-section of precursor 1. This area ratio A is expressed by the following formula.

```
Area ratio A = (cross-sectional area of reinforcing member 8

/ the entire cross-sectional area of precursor 1) × 100(%).
```

Note that the area ratio of the superconducting matrix section 2 in the axis-perpendicular cross-section of precursor 1 is an area ratio B, similarly to the above. The "area ratio A + area ratio B" of the superconducting matrix section 2 and the reinforcing member 8 in the axis-perpendicular cross-section of precursor 1 is, for example, 70 to 90%.

The intermediate layer 9 is a layer arranged between the reinforcing member 8 and the superconducting matrix section 2. The hardness (Vickers hardness, the same applies to the "hardness" appearing hereinafter) of the intermediate layer 9 is between the hardness of the Cu-Sn-based alloy of the superconducting matrix section 2 and that of the reinforcing member 8. The intermediate layer 9 is a layer for facilitating evenly processing, at the time of manufacturing precursor 1 (later mentioned area reduction process), and is a layer for restraining uneven deformation of the reinforcing member 8. The thinner the intermediate layer 9, the better the workability. The intermediate layer 9 contains, for example, Nb. Note that "the hardness of the Cu-Sn-based alloy" mentioned hereinabove is the hardness in the state of precursor 1, i.e., the hardness after later-described annealing (after softening). Further, the intermediate layer 9 does not necessarily have to be provided.

(Manufacturing Process)

Next, the following describes an example manufacturing process of the Nb$_3$Sn superconducting wire by a bronze process. A manufacturing process of the superconducting wire includes a first step of manufacturing a primary stack material (corresponding to the multifilament section 3), a second step of manufacturing a secondary multifilament billet (an article before precursor 1 is formed) by using the primary stack material and the like, a third step of forming precursor 1 by processing the secondary multifilament billet, and a fourth step of subjecting precursor 1 to a Nb$_3$Sn reaction heat treatment to make the superconducting wire.

The first step is a step for manufacturing a primary stack material (corresponding to the multifilament section 3; members at the stage of precursor 1 may be simply written in parenthesis hereinafter). The primary stack material (multifilament section 3) is manufactured as described in the following (a) to (g). (a) A Cu-Sn-based alloy bar (bronze matrix section 4) is prepared. (b) Holes are formed in seven positions at the center and therearound of the cross-section of the Cu-Sn-based alloy bar perpendicular to the axis of the Cu-Sn-based alloy bar. (c) Pure Nb rods (or Nb-based alloy rods) (Nb-based filaments 5) are inserted into the holes. (d) After (b) and (c), both ends of the Cu-Sn-based alloy bar (multifilament section 3), relative to its axial directions, are vacuum locked by welding. The vacuum locked product is the "primary multifilament billet". (e) The primary multifilament billet is extruded (subjected to reduction of area) by means of hydrostatic extrusion. (f) The extruded material is drawn (subjected to reduction of area) by means of wire drawing. During wire drawing, annealing is performed several times. Annealing is performed for preventing the Cu-Sn-based alloy from breaking due to its work hardening. (g) The drawn wire is finished by a hexagon die so that the wire has a hexagonal cross-section. In this way the primary stack material (multifilament section 3) is manufactured.

The second step is a step for manufacturing the secondary multifilament billet using the primary stack material and the like. The secondary multifilament billet is manufactured as described in the following (h) to (m). (h) A pure Ta rod (or a Ta-based alloy rod) (reinforcing member 8) is prepared. (i) A pure Nb sheet (intermediate layer 9) is wrapped around the outer periphery of the rod of pure Ta or the like (reinforcing member 8). (j) A plurality of primary stack materials (multifilament sections 3) are arranged on the outer periphery of the pure Nb sheet (intermediate layer 9). (k) A sheet of the pure Ta or the like (diffusion barrier layer 6) is wrapped around the outer periphery of a plurality of primary stack materials (superconducting matrix section 2). (l) These members integrated into one piece (the product manufactured through the above (h) to (k)) are inserted into a Cu pipe (stabilization copper layer 7). (m) After (l), both ends of the Cu pipe (stabilization copper layer 7), relative to its axial directions, are vacuum locked by welding. This vacuum locked product is the "secondary multifilament billet".

The third step is a step for processing the secondary multifilament billet to form precursor 1. This step includes the following (n) and (o). (n) The secondary multifilament billet is extruded (subjected to reduction of area) by means of hydrostatic extrusion. (o) The extruded material is drawn (subjected to reduction of area) by means of wire drawing. This wire drawing is performed in such a manner that the cross-section of the wire perpendicular to the axis of the wire ultimately has a rectangular shape. Further, as in the above (f), annealing is performed several times during the wire drawing. In this way, precursor 1 is manufactured (the manufactured product at this stage is "precursor 1").

The fourth step is a step of generating a $Nb_3Sn$ layer by reaction heat treatment (diffusion heat treatment) process to make precursor 1 into a superconducting wire. The $Nb_3Sn$ reaction heat treatment is performed for, for example, 80 to 200 hours at, for example, 650 to 720°C. Through this $Nb_3Sn$ reaction heat treatment, a layer of $Nb_3Sn$ compound is formed at the interface between the bronze matrix section 4 (Cu-Sn-based alloy) and the Nb-based filament 5. In this way, a $Nb_3Sn$ superconducting wire is manufactured.

(Test)

A plurality of superconducting wires were manufactured through the above described manufacturing process. Then, the 0.2% yield strength and the critical current density of each of the superconducting wires were measured.

The 0.2% yield strength was measured by dipping the superconducting wire into liquid helium (temperature 4.2K), and then performing a tension test of the superconducting wire. The acceptance criterion of the 0.2% yield strength in this test was 325 (MPa) or higher.

The critical current density is measured and calculated as follows. The critical current was measured by means of four probe method in liquid helium (temperature 4.2K), at an external magnetic field of 16T (Tesla). By dividing the current value by the entire cross-sectional area of the superconducting wire, the critical current density was calculated. The acceptance criteria of the critical current density in this test was 125 ($A/mm^2$) or higher, and preferably the acceptance criteria was 150 ($A/mm^2$) or higher.

As indicated in Table 1, test pieces a to f of the superconducting wires were prepared. Test pieces a and b were comparative examples. The conditions of the test pieces a to f were as follows. The reinforcing member 8 was formed with pure Ta (except for the test piece a having no reinforcing member 8). The intermediate layer 9 was formed with pure Nb. The "area ratio A + area ratio B" of the superconducting matrix section 2 and the reinforcing member 8 in the cross-section of the superconducting wire perpendicular to the axis of the superconducting wire (axis-perpendicular cross-section of the superconducting wire) was unified to approximately 80%. The diameter of the Nb-based filaments 5 were unified to approximately 4 $\mu$m. Note that the ratio of the diameter D5 of the Nb-based filament 5 and the equivalent diameter D8 of the reinforcing member 8, i.e., "D5/D8", is within the above mentioned range of 0.001 to 0.015 for the test pieces c to f. The wire height (the short side length of the axis-perpendicular cross-section of the superconducting wire, corresponding to H of the precursor) was unified to 1.04 mm. The wire width (the long side length of the axis-perpendicular cross-section of the superconducting wire, corresponding to W of the precursor) was unified to 1.56 mm. The other conditions are indicated in Table 1. The "Ta area ratio" in Table 1 is the area ratio A of the reinforcing member 8. The "Sn concentration" is the concentration of Sn in the bronze matrix section 4.

[Table 1]

| Test Pieces | Ta Area Ratio (%) | Sn Concentration (%) | Critical Current Density ($A/mm^2$) | 0.2% Yield Strength (MPa) |
|---|---|---|---|---|
| a | 0 | 14 | 180 | 200 |
| b | 10.8 | 14 | 165 | 295 |
| c | 17.3 | 14 | 156 | 356 |

(continued)

| Test Pieces | Ta Area Ratio (%) | Sn Concentration (%) | Critical Current Density (A/mm$^2$) | 0.2% Yield Strength (MPa) |
|---|---|---|---|---|
| d | 23.8 | 14 | 137 | 433 |
| e | 17.3 | 15 | 185 | 349 |
| f | 23.8 | 15 | 161 | 421 |

The test results are shown in Table 1 and FIG. 2. FIG. 2 is a graph showing the relation between the area ratio A of the reinforcing member 8 (see FIG. 1. hereinafter, see FIG. 1 for parts mentioned hereinabove) and the 0.2% yield strength (the vertical axis on the right side of the figure). FIG. 2 is a graph showing the relation between the area ratio A of the reinforcing member 8 ("Ta area ratio" shown by the horizontal axis in the figure) and the critical current density for the entire cross-sectional area (vertical axis on the left side of the figure). The test results are as follows.

(0.2% yield strength)

The 0.2% yield strength increased with an increase in the area ratio A of the reinforcing member 8. From this, the relation between the 0.2% yield strength and the area ratio A of the reinforcing member 8 is expressed by an approximation straight line L1 (broken line). The 0.2% yield strength was higher than the acceptance criteria of 325 MPa, with test pieces c to f having the reinforcing member 8 occupying an area ratio A of 15% or higher. The 0.2% yield strength was lower than the above mentioned acceptance criteria, with test pieces a and b having the reinforcing member 8 occupying an area ratio A of less than 15%.

(Critical Current Density)

The critical current density was as follows for test pieces a to d with the Sn concentration of 14% by mass. The critical current density decreased, with an increase in the area ratio A of the reinforcing member 8. From this result, the relation between the critical current density and the area ratio A of the reinforcing member 8 is expressed by the approximation straight line L2 (chain double-dashed line). The critical current density was more than the acceptance criteria of 125 (A/mm$^2$) for test pieces a to d having the reinforcing member 8 occupying an area ratio A of 25% or less. Thus, the critical current density is predicted to fall short of the acceptance criteria, when the area ratio A of the reinforcing member 8 is higher than 25%, based on the approximation straight line L2.

The critical current density was as follows for test pieces e and f with the Sn concentration of 15% by mass. The critical current density of test piece f having a higher area ratio A of the reinforcing member 8 was lower than that of test piece e. From this result, the relation between the critical current density and the area ratio A of the reinforcing member 8 is expressed by the approximation straight line L3 (chain double-dashed line thinner than L2), as in the case of test pieces a to d. When comparing test pieces c and e with the same area ratio A of the reinforcing member 8 and the different Sn concentration, the critical current density was higher in test piece e having the higher Sn concentration. Similarly, when test pieces d and f are compared, the critical current density was larger in test piece f with the higher Sn concentration. With test pieces e and f having the reinforcing member 8 occupying an area ratio A of 25% or less, the critical current density was 150 (A/mm$^2$), which is the preferable acceptance criteria, or higher. Thus, the critical current density is predicted to fall short of the above mentioned preferable acceptance criteria, when the area ratio A of the reinforcing member 8 is higher than 25%, based on the approximation straight line L3.

Further, as hereinabove mentioned, the critical current density was larger with the test piece having a higher Sn concentration. In other words, the critical current density was lower in the test piece with the lower Sn concentration. From this, it is possible to predict that the critical current density may be lower than the acceptance criteria, if the Sn concentration of test pieces c and d is reduced, specifically if the Sn concentration is reduced to less than 13.5% by mass.

(Effect)

Next, the effects of precursor 1 shown in FIG. 1 are described. Precursor 1 is used for manufacturing a Nb$_3$Sn superconducting wire. Precursor 1 includes: a superconducting matrix section 2 in which Nb-based filaments 5 containing pure Nb or a Nb-based alloy are arranged in a bronze matrix section 4 (Cu-Sn-based alloy); a diffusion barrier layer 6 arranged on an outer periphery of the superconducting matrix section 2; a stabilization copper layer 7 arranged on the outer periphery of the diffusion barrier layer 6; and a reinforcing member 8 arranged in the superconducting matrix section 2, and containing pure Ta or a Ta-based alloy.

(Effect 1-1)

The reinforcing member 8 has an area ratio A of 15 to 25% in the axis-perpendicular cross-section of precursor 1. Therefore, the superconducting wire manufactured by using precursor 1 has a higher strength than a traditional superconducting wire manufactured by using a precursor whose area ratio A is less than 15% (see FIG. 2). Further, the superconducting wire manufactured by using precursor 1 has a higher critical current density than a superconducting wire manufactured by using a precursor whose area ratio A is higher than 25% (see FIG. 2).

(Effect 1-2)

The Sn concentration in the bronze matrix section 4 (Cu-Sn-based alloy) of the superconducting matrix section 2 is 13.5% by mass or higher. Therefore, it is possible to raise the critical current density higher than the case where the Sn concentration is less than 13.5% by mass. That is, it is possible to restrain a drop in the critical current density which is attributed to an increase in the area ratio A of the reinforcing member 8.

The details of the effect are as follows. Increasing the area ratio A of reinforcing member 8 in the axis-perpendicular cross-section of precursor 1 causes a reduction in the area ratio of the superconducting matrix section 2 in the axis-perpendicular cross-section of precursor 1. In other words, the contact region of the Cu-Sn-based alloy (bronze matrix section 4) and the Nb-based filament is reduced. Therefore, simply increasing the area ratio A of reinforcing member 8 causes a reduction of the critical current density. In view of this, the Sn concentration in the bronze matrix section 4 (Cu-Sn-based alloy) is increased to 13.5% by mass or higher. This makes it possible to enhance the critical current density compared to that in cases of Sn concentrations of less than 13.5% by mass, and to restrain a drop in the critical current density attributed to an increase in the area ratio A of the reinforcing member 8.

(Effect 2)

Reinforcing member 8 is centralized at the center of the axis-perpendicular cross-section of the superconducting matrix section 2. Therefore, precursor 1 is more easily manufactured than cases of having reinforcing members 8 dispersed in superconducting matrix section 2. More specifically, reinforcing member 8 is easily arranged in the second step of manufacturing the secondary multifilament billet. This facilitates manufacturing of precursor 1.

(Effect 3)

Precursor 1 has a rectangular cross-section perpendicular to its axis. Therefore, when the superconducting wire manufactured by using precursor 1 is used as a winding wire for a coil, the dead space between each windings of the superconducting wire is reduced as compared with a superconducting wire with a circular cross-section perpendicular to its axis. As a result, the current density of the coil is improved, and the superconducting magnet using the coil is made compact.

(Effect 4)

The superconducting wire ($Nb_3Sn$ superconducting wire) of the present invention is manufactured by forming a $Nb_3Sn$-based superconductive phase by subjecting precursor 1 to a $Nb_3Sn$ reaction heat treatment. Such a superconducting wire brings about the above (Effect 1) to (Effect 3).

(Other Effects)

Precursor 1 includes an intermediate layer 9 arranged between the reinforcing member 8 and the superconducting matrix section 2. The hardness (Vickers hardness, the same applies to the "hardness" appearing hereinafter) of the intermediate layer 9 is between the hardness of the bronze matrix section 4 (Cu-Sn-based alloy) of the superconducting matrix section 2 and that of the reinforcing member 8. Thus, the deformation resistance differential between the reinforcing member 8 and the bronze matrix section 4 is reduced. This restrains uneven deformation of the reinforcing member 8 at the stage of manufacturing precursor 1.

(Modification 1)

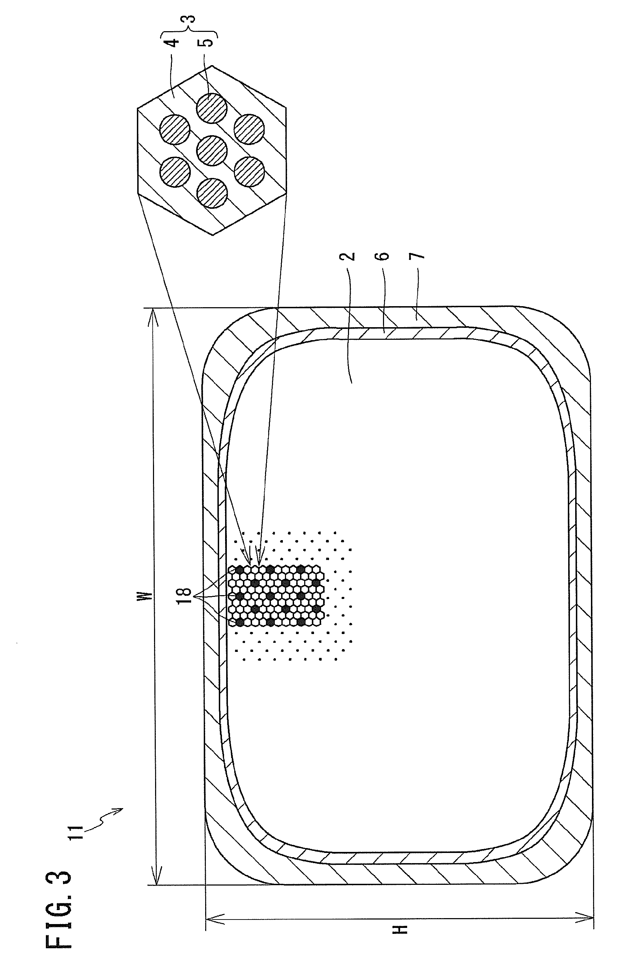

FIG. 3 shows a precursor 11 which is a modification of precursor 1. As shown in FIG. 1, the reinforcing member 8 of precursor 1 in the above embodiment is centralized at the center of the axis-perpendicular cross-section of the superconducting matrix section 2. It is however possible to disperse reinforcing members 18 in the superconducting matrix section 2 as shown in FIG. 3. The differences are further described below.

Precursor 11 includes reinforcing members 18 which are dispersed in the superconducting matrix section 2, in place of reinforcing member 8 of precursor 1 shown in FIG. 1. The reinforcing members 18 are dispersed by replacing multifilament sections 3 of precursor 1 shown in FIG. 1, with reinforcing members 18 shown in FIG. 3, for example. In this case, the total area ratio A of the reinforcing members 18 occupying the cross-section of precursor 11 perpendicular to its axis is 15 to 25%. Note that, in FIG. 3, reference numerals are given to only a part of the reinforcing members 18 (indicated by blackening).

(Modification 2)

Alternatively, it is possible to combine reinforcing member 8 of precursor 1 shown in FIG. 1, and reinforcing member 18 of precursor 11 shown in FIG. 3. That is, precursor 1 (11) may include both reinforcing members 8 (see FIG. 1) centralized at the center of the axis-perpendicular cross-section of the superconducting matrix section 2, and reinforcing members 18 (see FIG. 3) dispersed in the superconducting matrix section 2. In this case, the total area ratio A of the entire reinforcing members 8 and the reinforcing members 18 occupying the cross-section of precursor 1 (11) perpendicular to its axis is 15 to 25%.

Reference Signs List

1, 11    Precursor (Precursor For Nb$_3$Sn Superconducting Wire Manufacture)
2        Superconducting Matrix Section
4        Bronze Matrix Section 4(Cu-Sn-Based Alloy)
5        Nb-Based Filament
6        Diffusion Barrier Layer
7        Stabilization Copper Layer
8, 18    Reinforcing Member

**Claims**

**1.** A precursor for use in manufacturing a Nb$_3$Sn superconducting wire, comprising:

a superconducting matrix section in which a plurality of Nb-based filaments containing pure Nb or a Nb-based alloy are arranged in a Cu-Sn-based alloy;
a diffusion barrier layer having the superconducting matrix section arranged on its outer periphery;
a stabilization copper layer arranged on an outer periphery of the diffusion barrier layer; and
a reinforcing member arranged in the superconducting matrix section, which contains pure Ta or a Ta-based alloy,
wherein the reinforcing member occupies an area ratio of 15 to 25% of a cross-section of the precursor perpendicular to the axis of the precursor, and
wherein the Sn concentration in the Cu-Sn-based alloy of the superconducting matrix section is 13.5% by mass or higher.

**2.** The precursor according to claim 1, wherein the reinforcing members are centralized at a center of the cross-section of the superconducting matrix section perpendicular to its axis.

**3.** The precursor according to claim 1 or 2, wherein its cross-section perpendicular to its axis is rectangular.

**4.** A Nb$_3$Sn superconducting wire, manufactured by forming a Nb$_3$Sn-based superconductive phase by subjecting a precursor for manufacturing the Nb$_3$Sn superconducting wire according to any one of claims 1 to 3 to a Nb$_3$Sn reaction heat treatment.

FIG. 1

EP 2 752 856 A1

FIG. 2

EP 2 752 856 A1

FIG. 3

EP 2 752 856 A1

## INTERNATIONAL SEARCH REPORT

| | International application No. |
|---|---|
| | PCT/JP2012/071838 |

A. CLASSIFICATION OF SUBJECT MATTER

$H01B12/10$(2006.01)i, $C22C9/02$(2006.01)i, $C22C27/02$(2006.01)i, $H01B13/00$(2006.01)i, $H01F6/06$(2006.01)i, $C22F1/00$(2006.01)n, $C22F1/08$(2006.01)n

According to International Patent Classification (IPC) or to both national classification and IPC

B. FIELDS SEARCHED

Minimum documentation searched (classification system followed by classification symbols)

H01B12/10, C22C9/02, C22C27/02, H01B13/00, H01F6/06, C22F1/00, C22F1/08

Documentation searched other than minimum documentation to the extent that such documents are included in the fields searched

| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2001-357734 A (Kobe Steel, Ltd.),<br>26 December 2001 (26.12.2001),<br>entire text; all drawings<br>(Family: none) | 1-4 |
| Y | JP 2008-300337 A (Kobe Steel, Ltd.),<br>11 December 2008 (11.12.2008),<br>paragraph [0028]<br>& WO 2008/149644 A1 | 1-4 |
| Y | JP 2009-059652 A (Kobe Steel, Ltd.),<br>19 March 2009 (19.03.2009),<br>fig. 3<br>& EP 2031668 A2<br>fig. 3 | 1-4 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 19 September, 2012 (19.09.12) | 02 October, 2012 (02.10.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2012/071838

C (Continuation).    DOCUMENTS CONSIDERED TO BE RELEVANT

| Category* | Citation of document, with indication, where appropriate, of the relevant passages | Relevant to claim No. |
|---|---|---|
| A | JP 09-082149 A  (Kobe Steel, Ltd.), 28 March 1997 (28.03.1997), paragraphs [0028] to [0033]; fig. 5 (Family: none) | 1-4 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10255563 A

- JP TOKUKAIHEI10255563 B